# EUROPEAN PATENT APPLICATION

(11) **EP 4 718 099 A1**
(43) Date of publication of application: **01.04.2026**
(21) Application number: 24203289.4
(22) Date of filing: 27.09.2024
(51) Int. Cl.: G01R 33/022, G01R 33/12

(54) **GRADIOMETER COIL SYSTEM AND DIAGNOSTIC DEVICE**

(71) Applicant: Fraunhofer-Gesellschaft zur Förderung der angewandten Forschung e.V., 80686 München (DE)
(72) Inventor: KRETOV, Egor, 23562 Lübeck (DE); GRÄSER, Matthias, 23562 Lübeck (DE)
(74) Representative: 2SPL Patentanwälte PartG mbB

(57) **Abstract**

Provided is a gradiometer coil system (100; 302; 304; 306) for measuring a magnetic field emanating from a specimen located within the coil system (100; 302; 304; 306). The system comprises at least one receiving coil section (102; 202; 302a), which is sensitive to the mag netic field. Additionally, the system includes at least one compensation coil section (104a, ..., 104d; 204a, ..., 204d; 302b) connected in series with the receiving coil section (102; 202; 302a). The compensation coil section (104a, ..., 104d; 204a, ..., 204d; 302b) is arranged to compensate for external magnetic fields affecting the receiving coil section (102; 202; 302a). Furthermore, the area enclosed by the compensation coil section (104a, ..., 104d; 204a, ..., 204d; 302b) is smaller than the area enclosed by the receiving coil section (102; 202; 302a).

## Description

### Field

The present disclosure relates to Gradiometer coil system for measuring fields emanating from a specimen within the coils system and to a diagnostic device having a gradiometer coil system.

### Background

In various areas of technology, it is necessary to measure weak alternating magnetic fields. Said measurements often must be performed at the presence of external magnetic fields which may even be stronger than the magnetic field to be measured. The effect of the external magnetic field, therefore, needs to be compensated to be sensitive to the weak field. In some applications, the external field may be generated by a disturber, often resulting in fields that are homogeneous in the area the magnetic field to be measured is present. In other applications, the external field may be generated by the application itself. For example, in some medical applications, the external magnetic field is generated by a field generator and used to excite the magnetic field to be measured. The external magnetic field may, for example, interact with tissue within a specimen, causing the generation of a magnetic field within the tissue. The measurement of the excited magnetic field may then allow to conclude on properties of the tissue. Examples for those applications are magnetic resonance imaging (MRI), nuclear magnetic resonance spectroscopy, magnetic particle imaging (MPI), and electromagnetic tomography. Other applications not directed to tissue but based on similar principles are metal detectors and wireless energy transfer. In all those applications, a disturbing external magnetic field may also be generated in the vicinity of the specimen/target, so that the field may no longer be homogeneous within the area of interest. The area of interest can be understood as the area in which a specimen or target to be examined can be placed. In the context of the embodiments described herein, any signal not being the magnetic signal to be measured may be called an external signal.

One approach to compensate external signals is to use gradiometer coils/gradiometer coil systems. Gradiometer coils consist of at least two sections, a receiving coil section that is sensitive to the magnetic field and a compensation coil section. The receiving coil section and the compensation coil section are serially connected and geometrically arranged is such a way that the currents/voltages induced by a uniform external field neutralize each other. The magnetic field to be measured, on the other hand, is not uniform, since it normally emanates from a position within the gradiometer coil system and currents/voltages of different strengths are induced in different sections of the gradiometer coils. Hence, the magnetic fields within the receiving coil section and the compensation coil section do not compensate each other and can therefore be measured to conclude on the properties of the specimen. Gradiometer coil systems often exhibit the shape of a solenoid, but other geometries and flat structures are also feasible.

For homogeneous magnetic fields, the area of the compensation coil section needs to be identical to the area of the receiving coil section. This means that a major part of the coil system is not used for measurements, but only for compensation, which increases both the energy consumption and volume requirements for the measurement setup.

Therefore, there is a demand for a more flexible and compact gradiometer coils system.

### Summary

An embodiment relates to a gradiometer coil system for measuring a magnetic field emanating from a specimen within the coil system. The gradiometer coil system comprises at least one receiving coil section that is sensitive to the magnetic field and at least one compensation coil section connected in series with the receiving coil section that is arranged such that an external magnetic field is compensated in the receiving coil section. An area enclosed by the compensation coil section is smaller than an area enclosed by the receiving coil section.

The receiving coil section refers to the part of the coil system that is specifically designed to detect and measure the magnetic field emanating from a specimen (i.e., the object or area of interest). It is sensitive to weak magnetic fields within a defined measurement range. Its primary purpose is to generate a signal that is indicative of the magnetic field originating from the specimen. The magnetic field induces a current in the receiving coil, which is then used for analysis. This section is sensitive to localized, inhomogeneous magnetic fields near the specimen, allowing for precise measurement of the magnetic signals relevant to the application. The compensation coil section is the part of the coil system that is connected in series with the receiving coil section and is used to cancel out or reduce the effect of external magnetic fields that might interfere with the measurement. The main role of the compensation coil section is to generate an opposing magnetic response to external, homogeneous or inhomogeneous magnetic fields (e.g., environmental noise or interference) that affect the receiving coil. By doing so, it compensates for these unwanted fields, allowing the receiving coil to be sensitive on the magnetic field or signals from the specimen. The coil sections (both the receiving coil section and the compensation coil section) do not necessarily need to have a single winding. In fact, they can consist of multiple windings depending on the design requirements and the specific application. The use of multiple windings may offer more flexibility in terms of sensitivity, compensation, and adjustability, which can be beneficial in many applications, particularly where precise measurements of weak magnetic fields are required.

The compensation coil section encloses a smaller area compared to the receiving coil section. This reduces the overall size and volume of the gradiometer coil system, which may be especially beneficial in applications where space is limited, such as in wearable devices or compact diagnostic systems.

To achieve compensation without complex additional circuitry, a first winding direction of coils in the receiving coil section is opposite to a second winding direction of coils in the compensation coil section such that the induced voltages cancel automatically, for example if the geometric arrangement is such that the magnetic flux of the external magnetic field is equal through both, the compensation coil section and the receiving coil section.

In some embodiments, the area enclosed by the compensation coil section is outside of the area enclosed by the receiving coil section. This arrangement may serve to reduce the area of the compensation coil section if an inhomogeneous external magnetic field is present that has a larger field strength in areas apart from the specimen. If the external magnetic field is not uniform and its strength is stronger farther away from the specimen, positioning the compensation coil outside of the receiving coil takes advantage of this gradient. The compensation coil can be placed in regions where the external field is stronger, allowing for better compensation of the field with less coil area compared to if the compensation coil were placed closer to the specimen. As a result, fewer windings or a smaller coil area are needed to cancel the external field, making the system more compact and efficient.

In some embodiments, the gradiometer coil system further comprises an excitation coil system to generate an exciting magnetic field, the exciting magnetic field causing the magnetic field emanating from the specimen. Incorporating an excitation coil system, the magnetic field emanating from the specimen can be induced in a controlled manner. This ensures that the magnetic response of the specimen can be measured precisely, as it is generated in response to a known excitation field. This is particularly important in applications like Magnetic Resonance Imaging (MRI) or Magnetic Particle Imaging (MPI), where the magnetic response is a function of the applied excitation field. The inhomogeneous magnetic field generated by the excitation coil system may be compensated by means of the compensation coils section such that a magnetic field can be precisely measured be the receiving coil section.

In some embodiments, the area enclosed by the receiving coil section is within an area enclosed by the excitation coil system. If the receiving coil section is within the excitation coil system, the compensation coil section may be placed close to the excitation coil system to consume only little area. For example, the area enclosed by the compensation coil section is between the area enclosed by the receiving coil section and the excitation coil system.

According to some embodiments, the area enclosed by the compensation coil section is less than 80% of the area enclosed by the receiving coil section. Depending on the implementational details, the area consumed by the compensation coil section may be further decreased to be less than 70%, 60% or 50% of the area enclosed by the receiving coil section.

According to some embodiments, the receiving coil section and the compensation coil section have co-planar coils to allow for an efficient implementation.

According to some embodiments, the area enclosed by the compensation coil section is adjustable. The ability to adjust the area enclosed by the compensation coil section allows for dynamic tuning of the compensation coil's effectiveness in neutralizing external magnetic fields. Depending on the strength, direction, or inhomogeneity of the external field, the compensation coil's area can be optimized to ensure precise and effective compensation. This flexibility enhances the system's adaptability to different environments with varying levels of interference. In applications where the external magnetic field may change over time (for example, mobile systems or devices used in varying locations), the adjustable coil area provides the flexibility to adapt to new conditions. This makes the system more resilient to environmental changes for stationary devices also and ensures consistent performance across different settings.

According to some embodiments, the compensation coil section comprises at least two windings, wherein at least one winding can be disconnected from the receiving coil section to adjust the area of the compensation coil section.

An embodiment of a diagnostic device to measure a magnetic field emanating from a specimen comprises a gradiometer coil system according to the embodiments disclosed herein. The design of the gradiometer coil system enables the diagnostic device to be compact and efficient. This can be important for wearable or portable devices (e.g., helmets for brain scanning or small diagnostic tools), where space and energy efficiency are key considerations.

Some embodiments of diagnostic devices are shaped to be wearable as a helmet for a human head.

According to some embodiments, the device comprises at least two gradiometer coil systems connected in series or in parallel. Using multiple gradiometer coil systems connected in series or parallel may improve the overall sensitivity and accuracy of the diagnostic device. By combining the outputs of two or more gradiometer systems, the device may capture finer details in the magnetic field emanating from the specimen, leading to more precise measurements. This is particularly beneficial in applications where detecting weak or subtle magnetic signals is crucial, such as in medical diagnostics or material analysis. Using multiple coil systems can also extend the spatial coverage of the diagnostic device. Each gradiometer system can be focused on different regions of the specimen, allowing the device to measure the magnetic field over a larger area or from multiple angles simultaneously. This can lead to better spatial resolution, which is important for imaging applications where fine details of the magnetic field need to be captured (e.g., brain imaging, cardiac diagnostics).

To connect to readout and/or excitation signal sources, some embodiments comprise a signal terminal connected to the receiving coil section to provide a signal indicative of the magnetic field emanating from the specimen and/or an excitation signal terminal to receive an excitation signal to cause the generation of an exciting magnetic field within the device.

### Brief description of the Figures

Some examples of apparatuses and/or methods will be described in the following by way of example only, and with reference to the accompanying figures, in which
Fig. 1 schematically illustrates an embodiment of a gradiometer coil system;
Fig. 2 schematically illustrates a further embodiment of a gradiometer coil system; and
Fig. 3 schematically illustrates an embodiment of a diagnostic device.

### Detailed Description

Some examples are now described in more detail with reference to the enclosed figures. However, other possible examples are not limited to the features of these embodiments described in detail. Other examples may include modifications of the features as well as equiv alents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

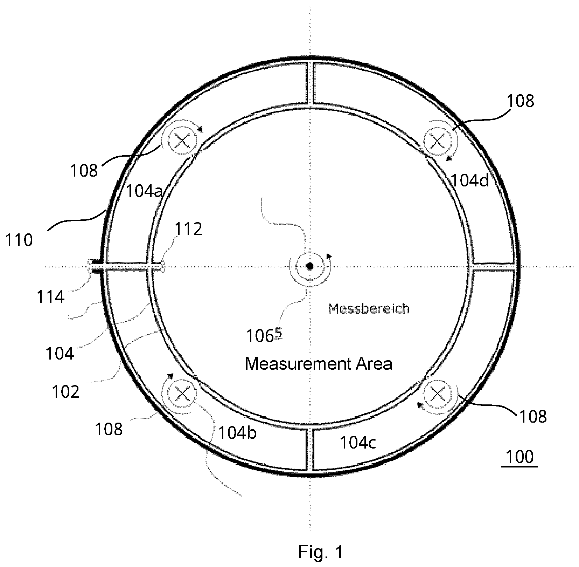

Fig. 1 schematically illustrates a possible design of an embodiment of a gradiometer coil system 100.

The gradiometer coil system 100 can be used to measure a magnetic field emanating from a specimen within the coil system. The gradiometer coil system 100 exhibits a receiving coil section (contour) 102 that is sensitive to the magnetic field and four compensation coil sections (contours) 104a, ..., 104d connected in series with the receiving coil section 102. The compensation coil sections 104a, ..., 104d are arranged such that an external magnetic field is compensated in the receiving coil section 102. In the planar geometry illustrated in Fig. 1, this is achieved in that the winding direction 106 of the coil/contour of the receiving coil section 102 is opposite to the winding direction 108 of the coils/contours forming the compensation coil sections 104a, ..., 104d so that a magnetic field passing through the coils induced opposing voltages in the receiving coil section 102 and the compensation coil sections 104a, ... , 104d, respectively. Although the voltages induced in the receiving coil section 102 and the compensation coil sections 104a, ..., 104d cancel, an area enclosed by the compensation coil sections 104a, ..., 104d is smaller than an area enclosed by the receiving coil section 102. The area enclosed by the compensation coil sections is 104a, ..., 104d is outside of the area enclosed by the receiving coil section 102.

As illustrated in fig. 1, a receiving coil section 102 and a compensation coil sections 104a, ... , 104d may be implemented using a single wire wound to form coils with a different winding direction so that the coils are intrinsically connected in series. In other embodiments, however, the different coil sections may be built individually and electrically connected in series afterwards. Receiving coils sections and compensation coils sections are generally understood as arrangement of conductors that form a coil in the sense that a voltage is induced between two points within the coil if a magnetic field passes through the coil.

In the implementation illustrated in fig. 1, the specimen may be placed within the measurement area which is enclosed by the receiving coil section 102.

The Gradiometer coil system 100 of fig. 1 further comprises an excitation coil system 110 to generate an exciting magnetic field that can cause or generate the magnetic field emanating from a specimen. In the implementation of fig. 1, the excitation coil system 110 is composed of a single winding enclosing both, the receiving coil section 102 and the compensation coil sections 104a, ..., 104d. In further embodiments, however, the excitation coil system 110 may also be composed of multiple windings. In some embodiments, it may also deviate from a planar geometry.

The gradiometer coil system 100 further comprises a signal terminal 112 connected to the receiving coil section 102 to receive a signal indicative of the magnetic field emanating from the specimen as well as an excitation signal terminal 114 to receive an excitation signal to cause the generation of an exciting magnetic field.

In other words, a principal design of a gradiometer coil system 100 is shown in fig. 1. A coil 110 can be connected to a generator via terminal 114 to generate an alternating field that is required to excite measurement signals within a specimen present in the measurement area. The receiving coil system consists of at least one main receiver winding (contour) 102 and at least one compensation winding (contour) 104a, ..., 104d, which are connected in series. A receiver circuit can be connected to terminal 112.

The main receiving winding 102 reacts sensitively to magnetic field sources that are located within the measuring range (the measurement area) or in its immediate vicinity. The field direction in the main receiving winding 102 and the compensation windings 104a, ..., 104d, is opposite. This is illustrated by the opposing current flows, which are shown by arrow 106 for the main receiving winding and arrow 108 for the compensation windings. The number of turns in the main and compensation windings can be the same or different.

In the embodiment illustrated in fig. 1, a field generated by coil 110 has an inhomogeneous distribution in space, being stronger in the vicinity of coil 110. Hence, the area of the compensation windings 104a, ..., 104d can be reduced to achieve a balance between the currents and voltages in the main receiving winding 102 and compensation windings 104a, ..., 104d.

In further embodiments, the geometry may be chosen to be more complicated and deviating from an entirely planar geometry. Also, one or all of the receiving coil section 102, the compensation coil section 104 and the excitation coil system 110 may comprise more than one winding or windings of a more complex geometry such as for example spiral, square, zig-zag, meander, Hilbert or fractal winding patterns.

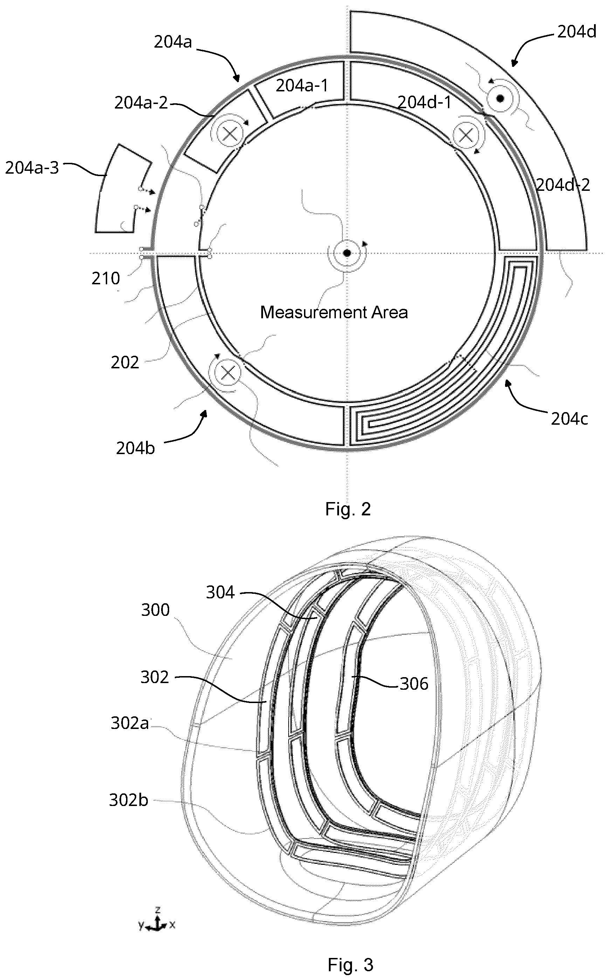

An embodiment illustrating some of the possible more complex geometries of compensation coil sections 204a, ..., 204d is illustrated in fig. 2. These and further forms can be arbitrarily combined and optionally also used for the receiving coil section 202 and for the excitation coil system 210.

As illustrated in fig. 2, the area enclosed by the compensation coil section 204a is adjustable. While two windings 204a-1 and 204a-2 are always connected serially, winding 204a-3 can be connected to the other windings or it can be disconnected to vary the area enclosed by compensation coil section 204a. In other words, compensation coil section 204a comprises at least two windings and wherein at least one winding can be disconnected from the receiving coil section. Winding 204a-3 of compensation coil section 204a is switchable or removable from compensation coil section 204a. In alternative implementations, a compensation coil section may also be physically movable within the gradiometer coil system to vary the magnetic flux passing through the coil.

While the areas enclosed by the compensation coil sections 104a, ..., 104d of fig. 1 is always between the area enclosed by the receiving coil section 102 and the excitation coil system 110, the compensation coil section 204d of fig. 2 has two windings 204d-1 and 204d-2, wherein only the area enclosed by winding 204d-1 is between the excitation coil system 210 and the receiving coil section 202. Winding 204d-2 is outside the excitation coil system 210. To also contribute to compensation, the winding direction of winding 204d-2 is opposite to the winding direction of winding 204d 1. In other words, compensation windings 204d 1 and 204d-2 could be positioned from both sides of the source field coil (excitation coil system 210), whereby they are then connected in opposite directions. The field direction in the outer compensation winding (204d-2) coincides with the field direction of the main receiving winding (receiving coil section 202).

While figs. 1 and 2 disclose a single planar gradiometer coil system, further embodiments may also exhibit coil structures that form an array in which they are connected in parallel or in series.

As mentioned previously, embodiments of gradiometer coil systems may be used in diagnostic devices. Just as an example for such an application, fig. 3 illustrates three gradiometer coil systems 302, 304, and 306 that are included in a helmet for a human head. While the gradiometer coil systems have co- planar receiving coil sections and compensation coil sections (see, for example, receiving coil section 302a and compensation coil section 302b), there shape is adapted to follow the contour of a human head. In further embodiments, the coil sections may also be implemented to form a 3-dimensional shape, that is, they do not necessarily have to be planar.

Depending on the implementation, the two gradiometer coil systems 302, 304, and 306 can be operated independently, be connected in series or in parallel. In other words, in the embodiment illustrated in fig. 3, the coils are designed to conform to the anatomical shape of the head within the helmet 300. The coil geometry could be adapted to complex shapes, requiring only that the voltages/currents generated at the receiving coil section 302a compensation coil sections 302b are equal. It is to be noted that the coil system to generate the exciting magnetic field (the alternating field source coil) is not shown in Fig 3.

While fig. 3 clearly shows the coils of the receiving coil section that and of the compensation coil section for illustrative purposes, further embodiments may likewise partly or fully conceal the construction geometry within the walls or housing of the helmet for the diagnostic device to become wearable more conveniently. In other words, it is also possible to change the geometry to such an extent that the individual components are no longer clearly recognizable.

In summary, previously described gradiometer coil system reduces the area/volume occupied by the gradiometric receiving coil (the compensation coil section). This may enable the construction of energy-efficient measurement systems, as there is no need to use additional large gradiometer sections that are only used for compensation purposes. In some embodiments, a multi-part design of the compensation windings (the windings of the compensation coil section) makes it easier to adjust the balance state between the main and compensation windings. In the event of a possible failure of the coil windings, this design prevents the occurrence of induced high voltage at their terminals, which could be important for medical applications. While embodiments of the disclosed gradiometer coil systems can be used in arbitrary applications, some interesting applications are Magnetic Resonance Imaging (MRI), Nuclear Magnetic Resonance Spectroscopy, Magnetic Particle Imaging (MPI), metal detectors, wireless energy transfer, and electromagnetic tomography.

The aspects and features described in relation to a particular one of the previous examples may also be combined with one or more of the further examples to replace an identical or similar feature of that further example or to additionally introduce the features into the further example.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. Gradiometer coil system (100; 302; 304; 306) for measuring a magnetic field emanating from a specimen within the coil system (100; 302; 304; 306), comprising:
at least one receiving coil section (102; 202; 302a) that is sensitive to the magnetic field;
at least one compensation coil section (104a, ..., 104d; 204a, ..., 204d; 302b) connected in series with the receiving coil section (102; 202; 302a), arranged such that an external magnetic field is compensated in the receiving coil section (102; 202; 302a); wherein
an area enclosed by the compensation coil section (104a, ..., 104d; 204a, ..., 204d; 302b) is smaller than an area enclosed by the receiving coil section (102; 202; 302a).

2. The gradiometer coil system (100; 302; 304; 306) of claim 1, wherein a first winding direction (106) of coils in the receiving coil section (102; 202; 302a) is opposite to a second winding direction (108) of coils in the compensation coil section (104a, ..., 104d; 204a, ..., 204d; 302b).

3. The Gradiometer coil system (100; 302; 304; 306) of claim 1 or 2, wherein the area enclosed by the compensation coil section (104a, ..., 104d; 204a, ..., 204d; 302b) is outside of the area enclosed by the receiving coil section (102; 202; 302a).

4. The gradiometer coil system (100; 302; 304; 306) of any one of the preceding claims, further comprising an excitation coil system (110; 210) to generate an exciting magnetic field, the exciting magnetic field causing the magnetic field emanating from the specimen.

5. The gradiometer coil system (100; 302; 304; 306) of claim 4, wherein the area enclosed by the receiving coil section (102; 202; 302a) is within an area enclosed by the excitation coil system (110; 210).

6. The gradiometer coil system (100; 302; 304; 306) of claim 5, wherein the area enclosed by the compensation coil section (104a, ..., 104d; 204a, ..., 204d; 302b) is between the area enclosed by the receiving coil section (102; 202; 302a) and the excitation coil system (110; 210).

7. The gradiometer coil system (100; 302; 304; 306) of any one of the preceding claims, wherein the area enclosed by the compensation coil section (104a, ..., 104d; 204a, ..., 204d; 302b) is less than 80% of the area enclosed by the receiving coil section (102; 202; 302a).

8. The gradiometer coil system (100; 302; 304; 306) of any of claims 1 to 7, wherein the receiving coil section (102; 202; 302a) and the compensation coil section (104a, ..., 104d; 204a, ..., 204d; 302b) have co-planar coils.

9. The gradiometer coil system (100; 302; 304; 306) of any one of the preceding claims, wherein the area enclosed by the compensation coil section (104a, ..., 104d; 204a, ..., 204d; 302b) is adjustable.

10. The gradiometer coil system (100; 302; 304; 306) of claim 9, wherein the compensation coil section (104a, ..., 104d; 204a, ..., 204d; 302b) comprises at least two windings and wherein at least one winding can be disconnected from the receiving coil section (102; 202; 302a).

11. A diagnostic device to measure a magnetic field emanating from a specimen, the device comprising a gradiometer coil system (100; 302; 304; 306) of any one of the preceding claims.

12. The diagnostic device of claim 11, wherein the device is shaped to be wearable as a helmet (300) for a human head.

13. The diagnostic device of claim 11 or 12, the device comprising at least two gradiometer coil systems (100; 302; 304; 306) of any one of claims 1 to 10, the two gradiometer coil systems (100; 302; 304; 306) being connected in series or in parallel.

14. The diagnostic device of any one of claims 10 to 13, further comprising:
a signal terminal (112) connected to the receiving coil section (102; 202; 302a) to provide a signal indicative of the magnetic field emanating from the specimen.

15. The diagnostic device of claims 14, further comprising:
an excitation signal terminal (114) to receive an excitation signal to cause the generation of an exciting magnetic field within the device.
